Europäisches Patentamt

European Patent Office

Office européen des brevets

(11) Numéro de publication : **0 519 804 A1**

# (12) DEMANDE DE BREVET EUROPEEN

(21) Numéro de dépôt : **92401670.2**

(22) Date de dépôt : **16.06.92**

(51) Int. Cl.$^5$ : **G01R 19/00,** G01R 33/24, G01R 15/02

(30) Priorité : **18.06.91 FR 9107445**

(43) Date de publication de la demande :
**23.12.92 Bulletin 92/52**

(84) Etats contractants désignés :
**CH DE GB IT LI**

(71) Demandeur : **COMMISSARIAT A L'ENERGIE ATOMIQUE**
**31-33, rue de la Fédération**
**F-75015 Paris (FR)**

(72) Inventeur : **Beranger, Marc**
**63B, rue des Ayguinards**
**F-38240 Meylan (FR)**
Inventeur : **Duret, Denis**
**13 rue de Stalingrad**
**F-38100 Grenoble (FR)**

(74) Mandataire : **Mongrédien, André et al**
**c/o BREVATOME 25, rue de Ponthieu**
**F-75008 Paris (FR)**

(54) **Capteur de courant utilisant un magnétomètre directionnel à résonance.**

(57)     Ce capteur comprend un circuit magnétique (CM) qui comporte un entrefer et un dispositif qui fournit une tension (V2) représentative d'un champ magnétique engendré dans l'entrefer par un courant (IM), lorsque ce courant traverse le circuit. La valeur du champ est fonction de l'intensité du courant. Le dispositif est un magnétomètre directionnel à résonance (MD) comprenant un échantillon (2) comportant des spins résonants, placé dans l'entrefer et soumis à un champ magnétique de polarisation parallèle au champ engendré dans l'entrefer ou confondu avec celui-ci, et des moyens de mesure prévus pour exciter la résonance et détecter la résonance excitée, et pour fournir ladite tension représentative.

FIG. 7

EP 0 519 804 A1

La présente invention concerne un capteur de courant comprenant :

- un circuit magnétique qui comporte un entrefer, et

- un dispositif de mesure, apte à fournir une tension électrique représentative d'un champ magnétique H1ex qui est engendré dans l'entrefer par un courant électrique, lorsque ce courant électrique traverse le circuit magnétique, et dont la valeur est une fonction de l'intensité de ce courant électrique.

Le courant peut être un courant dont l'intensité est constante au cours du temps ou un courant alternatif dont la fréquence ne dépasse pas $10^5$ Hz environ.

De plus, le courant électrique peut être transporté par un conducteur électrique ou peut être le courant d'un faisceau de particules électriquement chargées.

L'invention s'applique en particulier à la mesure de faibles intensités électriques, par exemple de l'ordre de quelques dizaines de mA.

On connaît déjà par les documents

(1) La pince ampèremétrique E1 Chauvin Arnoux, Electronique Radio Plans 520, p.19 à 21, 1991.

(2) Electro PJP, Notice technique du constructeur p.1 à 9.

des capteurs de courant comprenant un circuit magnétique, qui comporte un entrefer, ainsi qu'un capteur magnétique constitué par un capteur à effet Hall qui est placé dans l'entrefer.

Lorsqu'un courant électrique traverse le circuit magnétique, un champ magnétique est engendré dans l'entrefer et ce champ magnétique est proportionnel à l'intensité du courant et inversement proportionnel à la longueur de l'entrefer.

En ce qui concerne les capteurs à effet Hall, on pourra également consulter le document suivant :

(3) Hall-effect devices, R.S. POPOVIC, Sensors and actuators, 17 (1989) 39-53.

D'autres capteurs de courant utilisant l'effet Hall sont également connus par les documents suivants :

(4) FR-A-2 584 195 (CHAUVIN-ARNOUX)

(5) EP-A-O 194 225 (LEM SA)

Les capteurs de courant utilisant l'effet Hall présentent des inconvénients, en particulier :

- ils ont une faible résolution, de l'ordre de 1 microtesla,

- ils présentent un décalage ("offset") lors d'une mesure, ce décalage étant de l'ordre de 1 mT,

- de tels capteurs ont un bruit qui est inversement proportionnel à la fréquence du signal mesuré, et

- ils sont sensibles aux contraintes mécaniques (voir en particulier le document (3) p.43).

Tous ces paramètres, qui sont liés à une sensibilité à la température, de l'ordre de 100 ppm/°C, ont pour effet de limiter la résolution en courant des capteurs utilisant l'effet Hall à une valeur de l'ordre de 1 mA dans le meilleur des cas.

D'autres capteurs de courant connus par les documents suivants

(6) US-A-4 616 174 (Jorgensen)

(7) A new current sensor based on the measurement of the apparent coercive field strength, Derac Son and Johannes D. Sievert, IEEE transactions on instrumentation and measurement, vol.38, n°6, décembre 1989, p.1080 à 1082

font appel aux non-linéarités du matériau magnétique constituant le circuit magnétique mentionné plus haut.

Dans les dispositifs décrits dans ces documents (6) et (7), ce circuit magnétique est soumis à un champ magnétique pulsé dont la valeur moyenne est nulle.

L'existence d'un courant à mesurer a pour effet de faire apparaître des composantes paires pour le flux magnétique présent dans le circuit magnétique.

On peut ainsi gagner environ un ordre de grandeur pour la résolution en courant par rapport aux capteurs utilisant l'effet Hall mais cela nécessite une certaine complication des circuits électroniques utilisés.

A ce sujet on se reportera également au document suivant :

(8) Documentation de la Société Danfysik, Jyllinge-Danmark, sur le transducteur de courant ULTRASTAB (marque déposée) 860R.

La présente invention résout le problème de l'obtention d'un capteur de courant qui comprend un circuit magnétique et un dispositif de mesure, comme on l'a indiqué plus haut, et dont la résolution en courant est nettement meilleure que celle des capteurs mentionnés précédemment et peut atteindre $10^{-2}$ mA, d'où un gain de deux ordres de grandeur sur la résolution en courant par rapport aux capteurs magnétiques utilisant l'effet Hall.

Pour résoudre ce problème, le capteur de courant objet de la présente invention est caractérisé en ce que le dispositif de mesure qu'il comporte est un magnétomètre directionnel à résonance comprenant :

- un échantillon qui est placé dans l'entrefer du circuit magnétique, qui est fait d'un matériau comportant des spins résonants et qui est soumis à un champ magnétique de polarisation parallèle au champ magnétique qui est engendré dans l'entrefer ou confondu avec ce champ engendré dans l'entrefer, et

- des moyens de mesure prévus pour exciter la résonance et détecter la résonance excitée, par l'intermédiaire de premiers moyens magnétiques placés au voisinage de l'échantillon, et pour fournir ladite tension électrique représentative.

On notera que la mesure de courants électriques constitue un domaine très éloigné de la magnétométrie à résonance qui concerne essentiellement la mesure d'anomalies du champ magnétique terrestre.

On a vu que le champ magnétique de polarisation pouvait être confondu avec le champ magnétique qui est engendré dans l'entrefer par le courant électrique traversant le circuit magnétique : dans ce cas, c'est ce courant électrique lui-même qui engendre le champ de polarisation.

Selon un mode de réalisation particulier du capteur objet de l'invention, les moyens de mesure comprennent des moyens de polarisation prévus pour engendrer le champ magnétique de polarisation Hb, celui-ci étant voisin de Ho où Ho est la valeur du champ magnétique appliqué à l'échantillon à la résonance, Ho étant défini par la relation de Larmor donnée plus loin.

Dans ce cas, les moyens de polarisation peuvent comprendre :

- une source de courant continu et
- une bobine magnétique qui est alimentée par cette source de courant continu et qui est prévue pour engendrer le champ magnétique de polarisation Hb.

On dispose alors d'un capteur conforme à l'invention dans lequel le champ magnétique de polarisation est approximativement constant au cours du temps.

Les moyens de mesure peuvent comprendre en outre des moyens d'asservissement, ou moyens de contreréaction, prévus pour engendrer, dans l'échantillon, par l'intermédiaire de deuxièmes moyens magnétiques, un champ magnétique de compensation qui compense le champ magnétique H1ex engendré dans l'entrefer, et pour fournir ladite tension électrique représentative.

L'utilisation de ces moyens d'asservissement conduit à une amélioration de la dynamique de mesure et de la linéarité du capteur objet de l'invention ainsi qu'à une indépendance des mesures vis-à-vis des caractéristiques géométriques de l'entrefer du circuit magnétique.

Néanmoins, on peut réaliser des capteurs conformes à la présente invention mais ne comportant pas de moyens de contre-réaction, c'est-à-dire des capteurs dans lesquels on ne compense pas le champ magnétique créé par le courant à mesurer.

Dans le cas d'un champ de polarisation engendré par un courant continu, il se pose un problème lié à la stabilité du champ de polarisation Hb, stabilité qui influe directement sur la mesure du courant qui traverse le circuit magnétique.

Pour résoudre ce problème, on utilise, selon un mode de réalisation préféré du capteur objet de l'invention, un champ de polarisation pulsé en créneaux, ce qui conduit à une meilleure résolution.

Plus précisément, selon ce mode de réalisation préféré, les moyens de mesure comprennent en outre des moyens de traitement prévus pour engendrer un courant en créneaux créant, dans l'entrefer, un champ magnétique qui est pulsé entre deux valeurs

$$Ho - Hb + H1ex \text{ et } Hb - Ho + H1ex$$

où Ho est la valeur du champ magnétique appliqué à l'échantillon à la résonance et Hb est le champ magnétique de polarisation, celui-ci étant voisin de Ho, et les deuxièmes moyens magnétiques reçoivent ce courant en créneaux qui est pulsé.

Les moyens d'asservissement peuvent comprendre un intégrateur, qui est commandé par les moyens de traitement, et un convertisseur tension-courant dont l'entrée est reliée à la sortie de l'intégrateur et dont la sortie alimente les deuxièmes moyens magnétiques.

Selon un premier mode de réalisation particulier, les moyens de traitement comprennent :

- des moyens électroniques prévus pour alimenter les premiers moyens magnétiques par un courant à la fréquence de Larmor correspondant à Ho et pour fournir en sortie un signal de tension dont les variations en fonction du champ magnétique appliqué à l'échantillon correspondent à la courbe de dispersion de cet échantillon,
- un premier dispositif électronique relié à la sortie des moyens électroniques et permettant un gain en tension valant alternativement +1 et -1,
- un échantillonneur-bloqueur dont l'entrée est reliée à la sortie du premier dispositif électronique et dont la sortie commande les moyens d'asservissement,
- une source de tension électrique,
- un deuxième dispositif électronique alimenté par cette source et permettant un gain en tension valant alternativement +1 et -1, et
- un autre convertisseur tension-courant dont l'entrée est reliée à la sortie du deuxième dispositif électronique et qui alimente les deuxièmes moyens magnétiques.

Selon un deuxième mode de réalisation particulier qui, contrairement au premier, utilise une détection synchrone, les moyens de traitement comprennent :

- des moyens électroniques prévus pour alimenter les premiers moyens magnétiques par un courant à la fréquence de Larmor correspondant à Ho et pour fournir en sortie, grâce à une détection synchrone commandée par un signal de tension à une fréquence audio, un signal de tension dont les variations en fonction du champ magnétique appliqué à l'échantillon correspondent à la dérivée de la courbe d'absorption de cet échantillon,
- un premier dispositif électronique relié à la sortie des moyens électroniques et permettant un gain en tension valant alternativement +1 et -1,
- un échantillonneur-bloqueur dont l'entrée est reliée à la sortie du premier dispositif électronique et dont la sortie commande les moyens d'asservissement,
- une source de tension électrique,
- un deuxième dispositif électronique alimenté par cette source et permettant un gain en tension valant alternativement +1 et -1, et

- un autre convertisseur tension-courant dont l'entrée est reliée à la sortie du deuxième dispositif électronique et qui alimente les deuxièmes moyens magnétiques.

Selon un troisième mode de réalisation particulier, qui utilise également une détection synchrone, les moyens de traitement comprennent :

- des moyens électroniques prévus pour alimenter les premiers moyens magnétiques par un courant à la fréquence de Larmor correspondant à Ho et pour fournir en sortie, grâce à une détection synchrone commandée par un signal de tension à une fréquence audio, un signal de tension dont les variations en fonction du champ magnétique appliqué à l'échantillon correspondent à la dérivée de la courbe d'absorption de cet échantillon,

- un échantillonneur-bloqueur dont l'entrée est reliée à la sortie des moyens électroniques et dont la sortie commande les moyens d'asservissement,

- une source de tension électrique,

- un moyen de sommation prévu pour fournir en sortie un signal de tension égal à la somme de cette tension et d'un signal issu de la détection synchrone à fréquence audio,

- un dispositif électronique relié à la sortie du moyen de sommation et permettant un gain en tension valant alternativement +1 et -1, et

- un autre convertisseur tension-courant dont l'entrée est reliée à la sortie du dispositif électronique et qui alimente les deuxièmes moyens magnétiques.

Dans une réalisation avantageuse du capteur objet de la présente invention, correspondant au cas où la polarisation est pulsée, ce capteur comprend en outre des moyens aptes à maintenir respectivement égale à Ho et à -Ho les valeurs maximale et minimale du champ de polarisation.

Les deuxièmes moyens magnétiques peuvent comprendre au moins une bobine magnétique qui est bobinée autour du circuit magnétique.

Dans une variante de réalisation, cette bobine magnétique est placée dans l'entrefer et bobinée autour de l'échantillon et l'axe de cette bobine est parallèle au champ H1ex.

De préférence les moyens de mesure comprennent un circuit résonant, qui incorpore les premiers moyens magnétiques et qui est accordé à la fréquence fo de la résonance, ainsi que des moyens aptes à maintenir le circuit résonant accordé à la fréquence fo.

Le capteur objet de l'invention peut comprendre en outre, autour des premiers moyens magnétiques et de l'échantillon, un moyen de protection vis-à-vis du champ magnétique terrestre.

Enfin, le capteur objet de l'invention peut comprendre en outre, autour des premiers moyens magnétiques et de l'échantillon, un moyen de protection vis-à-vis des champs électromagnétiques radiofréquence.

La présente invention sera mieux comprise à la lecture de la description d'exemples de réalisation donnés ci-après à titre purement indicatif et nullement limitatif, en faisant référence aux dessins annexés sur lesquels :

- la figure 1 illustre schématiquement un circuit magnétique utilisable dans la présente invention,

- la figure 2 est une vue schématique d'un magnétomètre utilisable dans la présente invention,

- la figure 3 représente une courbe de dispersion que l'on peut obtenir avec le magnétomètre de la figure 2,

- la figure 4 représente la courbe d'absorption d'un échantillon à spins résonants que comporte le magnétomètre de la figure 2, l'obtention de la courbe d'absorption ou de la courbe de dispersion s'effectuant simplement par un déphasage de 90° de la référence de la détection 18,

- la figure 5 est une vue schématique d'un autre magnétomètre utilisable dans la présente invention,

- la figure 6 représente une courbe qui est la dérivée de la courbe de la figure 4 et que l'on peut obtenir avec le magnétomètre de la figure 5,

- la figure 7 est une vue schématique d'un mode de réalisation particulier du capteur objet de l'invention,

- la figure 8 illustre schématiquement un autre circuit magnétique utilisable dans la présente invention,

- la figure 9 est une vue schématique d'un magnétomètre utilisable dans la présente invention, dans lequel le champ magnétique de polarisation est pulsé, le circuit magnétique n'étant pas représenté,

- la figure 10 est une vue schématique d'un autre magnétomètre utilisable dans l'invention et pourvu d'une détection synchrone,

- la figure 11 illustre schématiquement un dispositif électronique utilisé dans les magnétomètres représentés sur les figures 9 et 10,

- la figure 12 est un chronogramme montrant des signaux d'horloge utilisés dans les magnétomètres représentés sur les figures 9 et 10,

- la figure 13 représente des courbes champ magnétique-tension et temps-champ magnétique qui illustrent le fonctionnement des magnétomètres représentés sur les figures 9 et 10,

- la figure 14 est un autre chronogramme qui illustre également le fonctionnement des magnétomètres représentés sur les figures 9 et 10,

- la figure 15 illustre schématiquement et partiellement une variante de réalisation du magnétomètre représenté sur la figure 10,

- les figures 16 à 23 illustrent schématiquement diverses variantes de réalisation des magnétomètres des figures 9 et 10,

- la figure 24 illustre schématiquement la possibilité d'utiliser un blindage radio-fréquence pour l'échantillon à spins résonants,

- la figure 25 illustre schématiquement et partiellement un autre mode de réalisation particulier du capteur objet de l'invention,

- la figure 26 illustre les variations d'une capacité d'accord relative au capteur de la figure 25, et

- la figure 27 illustre schématiquement un écran magnétique vis-à-vis du champ magnétique terrestre, dont on peut munir un capteur conforme à la présente invention.

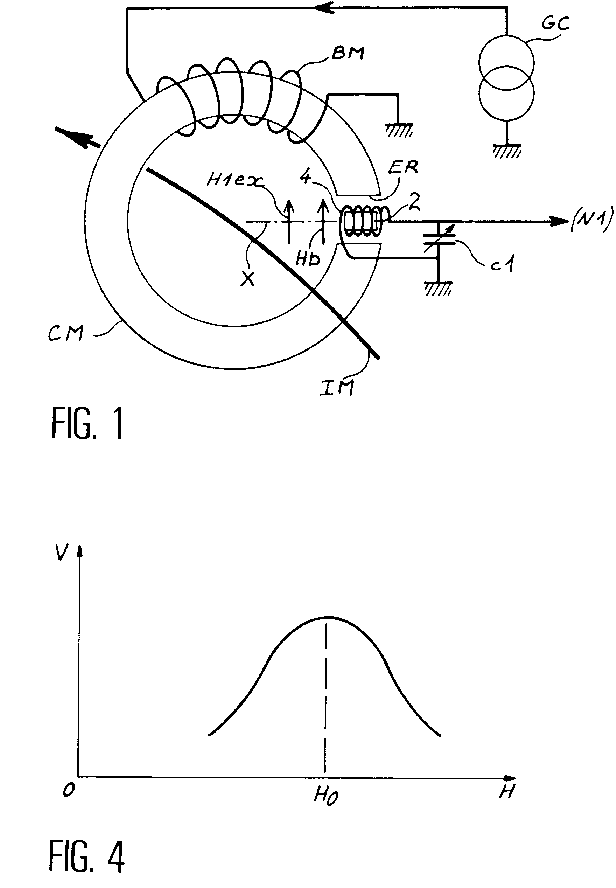

Sur la figure 1, on a représenté schématiquement un circuit magnétique CM utilisable dans un capteur conforme à la présente invention.

Ce circuit magnétique CM est fait d'un matériau magnétique à perméabilité élevée, par exemple un matériau ferromagnétique, et a par exemple la forme d'un tore.

Le circuit magnétique CM comporte un entrefer ER et entoure un courant électrique à mesurer IM.

Il en résulte alors un champ magnétique H1ex dans l'entrefer ER et la valeur de ce champ est donnée par la formule suivante :

$$H1ex = Nt.Iex/ep$$

où Nt représente le nombre de tours que fait le courant à travers le circuit magnétique (ce nombre de tours étant égal à 1 sur la figure 1)

Iex représente l'intensité du courant IM

ep représente l'épaisseur, ou longueur, de l'entrefer ER, exprimée en mètre, et a typiquement une valeur de quelques millimètres.

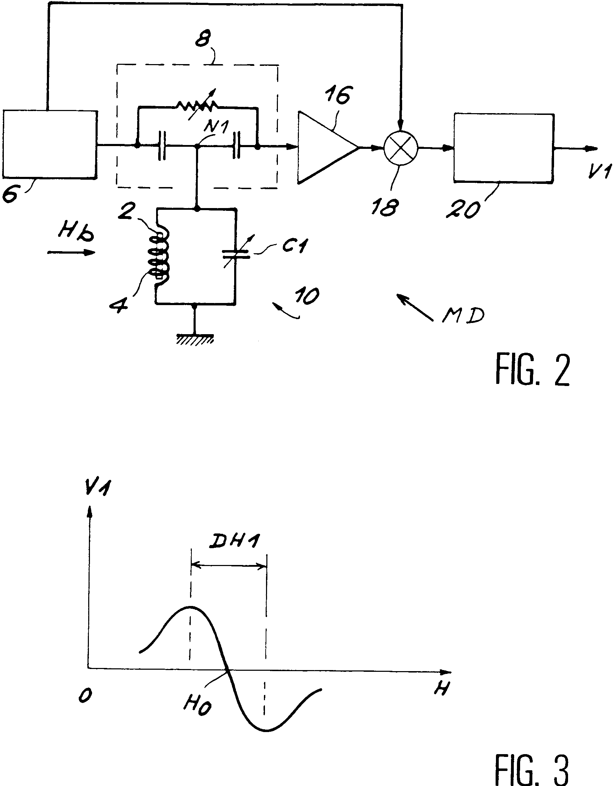

Sur la figure 2, on a représenté schématiquement un dispositif de mesure qui, avec le circuit magnétique représenté sur la figure 1, forme un capteur de courant conforme à l'invention.

Le dispositif de mesure représenté sur la figure 2 est un magnétomètre directionnel à résonance MD qui comprend un échantillon 2 fait d'un matériau possédant des spins électroniques résonants ainsi qu'une bobine d'excitation et de réception 4 qui entoure l'échantillon 2.

L'échantillon 2, muni de sa bobine 4, est placé dans l'entrefer ER (figure 1) de façon que l'axe X de la bobine 4 soit perpendiculaire au champ magnétique H1ex présent dans cet entrefer ER.

L'échantillon 2 est soumis à ce champ H1ex qui résulte du courant IM ainsi qu'à un champ magnétique de polarisation Hb parallèle à H1ex.

Ce champ magnétique de polarisation Hb est créé par une bobine magnétique BM (figure 1) qui est bobinée sur le circuit magnétique et qui est alimentée par un générateur de courant constant GC.

Le champ Hb est égal au nombre de tours de la bobine BM multiplié par l'intensité du courant issu du générateur GC, et divisé par l'épaisseur de l'entrefer.

Dans le cas où les spins électroniques résonnent, la fréquence fo de résonance de ces spins électroniques est donnée par la relation de Larmor :

$$fo = g.Mo.Ho/(2pi)$$

où pi est le nombre bien connu qui vaut environ 3,14 g est le rapport gyromagnétique de l'électron (g/2pi=28 GHz/T)

Ho représente le champ magnétique appliqué aux spins à la résonance (exprimé en A/m), et

$Mo = 4.pi.10^{-7}$ H/m.

A titre purement indicatif et nullement limitatif, fo est égal à 40 MHz et Hb à 1,4 mT.

Comme on le voit sur la figure 2, un générateur 6 de haute fréquence, réglé sur fo excite la résonance par l'intermédiaire d'un pont de mesure 8 et de la bobine 4 qui fait partie d'un circuit résonant 10, ce dernier étant accordé à la fréquence fo et comprenant, en plus de la bobine 4, un condensateur variable c1 monté entre les bornes de la bobine 4.

Sur la figure 2, on voit un point référencé N1 correspondant à une borne commune à la bobine 4 et au condensateur c1 et opposée à l'autre borne commune qui est mise à la masse.

Le pont de mesure 8 a pour fonction de découpler la réception de l'excitation.

Le magnétomètre représenté sur la figure 2 comprend en outre un amplificateur à faible bruit 16, un mélangeur équilibré 18 et un filtre passe-bas 20.

On remarquera que le pont de mesure 8 peut être supprimé à condition de prévoir une bobine réceptrice à la fois perpendiculaire à la direction du champ de polarisation dans l'entrefer et à l'axe de la bobine 4 alors émettrice et reliée au générateur 6, le circuit résonant 10 étant dans ce cas seulement relié à l'amplificateur 16 (configuration dite "de Bloch").

Le signal de haute fréquence, qui est disponible à la sortie du pont de mesure 8, est amplifié par l'amplificateur 16 et envoyé à l'entrée du mélangeur équilibré 18 dont le signal de référence est synchrone de l'excitation de haute fréquence.

Plus précisément, ce signal de référence est un signal qui a la même fréquence que celle du signal d'excitation envoyé par le générateur 6 au pont de mesure 8 mais dont l'amplitude est la phase peuvent être rendues différentes de celles de ce dernier signal.

La sortie du mélangeur 18 est filtrée par le filtre passe-bas 20 pour éliminer les résidus ainsi que des harmoniques de la haute fréquence.

En montant à la sortie du filtre passe-bas 20 un dispositif d'observation approprié non représenté, on peut alors obtenir, avec des phases appropriées pour le signal d'excitation et le signal de référence, la courbe de la figure 3 qui représente les variations de la tension de sortie du filtre 20 en fonction du champ magnétique H qui est appliqué à l'échantillon dans l'entrefer ER et qui est la somme du champ de polarisation Hb et du champ engendré par le courant à mesurer IM, la résonance ayant lieu lorsque H est égal à Ho.

La courbe de la figure 3, qui est appelée "courbe de dispersion" est ainsi utilisable pour la détermination du champ magnétique H1ex et donc de l'intensité Iex du courant à mesurer IM.

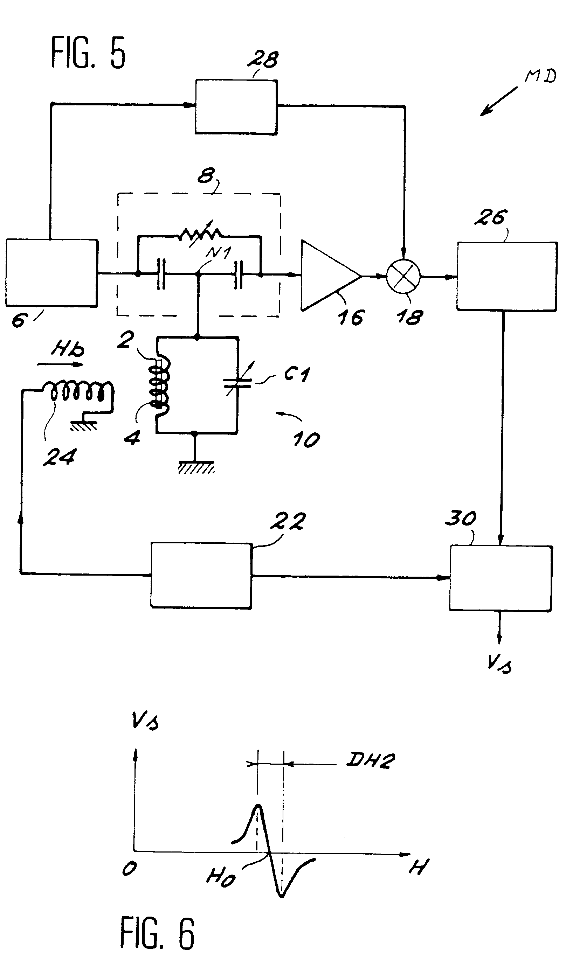

En choisissant convenablement les phases respectives du signal d'excitation et du signal de référence, on peut obtenir, à la sortie du filtre 20, une tension qui est alors notée V et dont les variations en fonction du champ magnétique H sont représentées sur la figure 4, la courbe correspondante étant appelée "courbe d'absorption".

En ce qui concerne le magnétomètre représenté sur la figure 2, on pourra se reporter au document suivant :

(9) Demande de brevet français n° 8809830 du 20 juillet 1988 et EP-A-0359598, D. Duret et M. Beranger.

On peut également utiliser un autre magnétomètre directionnel à résonance MD qui est schématiquement représenté sur la figure 5, en association avec le circuit magnétique CM de la figure 1 pour la mesure du courant IM.

La courbe que l'on peut obtenir avec le magnétomètre représenté sur la figure 5 et que l'on peut donc utiliser dans la présente invention est la dérivée de la courbe d'absorption.

Le magnétomètre de la figure 5 utilise l'échantillon 2, la bobine BM ainsi que la bobine 4, le générateur 6, le pont de mesure 8, le circuit résonant 10, l'amplificateur 16 et le mélangeur équilibré 18, agencés comme on l'a expliqué plus haut.

Le magnétomètre de la figure 5 comprend en outre un oscillateur 22, qui engendre un signal (courant d'agitation) ayant une fréquence-audio notée fm, et une bobine 24 qui reçoit ce signal et qui crée dans l'échantillon 2 un champ magnétique de fréquence fm appelé "champ d'agitation" ("dither field" dans les publications en langue anglaise) et surperposé au champ Hb.

La bobine 24 se trouve dans l'entrefer ER, est bobinée autour de l'échantillon 2 (ce que l'on ne voit pas sur la figure 5 pour plus de clarté) et son axe est parallèle au champ H1ex.

En variante, la bobine 24 pourrait être bobinée sur le circuit magnétique CM.

On indique à ce propos que la bobine BM, au lieu d'être bobinée sur le circuit magnétique CM, pourrait être placée dans l'entrefer ER et entourer l'échantillon 2, son axe étant parallèle au champ H1ex.

Dans le magnétomètre de la figure 5, le filtre passe-bas de la figure 3 est remplacé, à la sortie du mélangeur équilibré 18, par un filtre passe-bande 26 autour de la fréquence fm.

Un déphaseur 28 reçoit le signal de haute fréquence issu du générateur 6 et fournit au mélangeur équilibré 18 un signal de phase adéquate pour obtenir, à la sortie de ce mélangeur 18, la tension V de la courbe représentée sur la figure 4.

Un moyen de détection synchrone 30 à la fréquence fm, qui est commandé par un signal de référence issu de l'oscillateur 22, a son entrée reliée à la sortie du filtre 26 et fournit en sortie une tension Vs.

Ce signal de référence a une fréquence fm mais son amplitude et sa phase peuvent être rendues différentes de celles du signal fourni par l'oscillateur 22 à la bobine 24.

En montant à la sortie du moyen de détection synchrone 30 un moyen d'observation approprié (non représenté), on peut observer une courbe que l'on voit sur la figure 6, sans tension de décalage.

Cette courbe représente les variations de la tension Vs en fonction du champ H et constitue la dérivée de la courbe de la figure 4.

Les paramètres permettant d'optimiser les matériaux résonants et les amplitudes respectives du champ de haute fréquence et du champ d'agitation sont obtenus par un procédé qui est décrit dans le document (9).

On précise à ce propos que le champ de polarisation Hb doit être voisin de Ho dans les capteurs conformes à l'invention déjà décrits et, d'une manière générale, dans tous les modes de réalisation de la présente invention.

L'expression "Hb voisin de Ho" signifie que la valeur absolue de la différence entre Hb et Ho est inférieure à la moitié de la largeur de raie DH1 relative à la courbe de la figure 3, lorsqu'on utilise cette courbe pour la mise en oeuvre de l'invention, ou à la moitié de la largeur de raie DH2 de la figure 6, lorsqu'on utilise la courbe de la figure 6 pour la mise en oeuvre de l'invention.

Les capteurs de courant décrits en faisant référence aux figures 2 et 5 correspondent à des capteurs sans contre-réaction.

Il fournissent en sortie une tension qui est proportionnelle à l'intensité du courant à mesurer, la plage de mesure étant cependant relativement restreinte.

De tels capteurs sont plutôt utilisables pour une détection de "zéro", c'est-à-dire pour savoir si l'intensité d'un courant électrique est égale ou supérieure ou inférieure à l'intensité connue d'un courant de référence.

Pour une telle application, la bobine BM et le générateur GC ne sont d'ailleurs pas nécessaire et peuvent être supprimés : alors, le champ magnétique de polarisation est engendré par le courant IM lui-même (qui traverse le circuit magnétique CM).

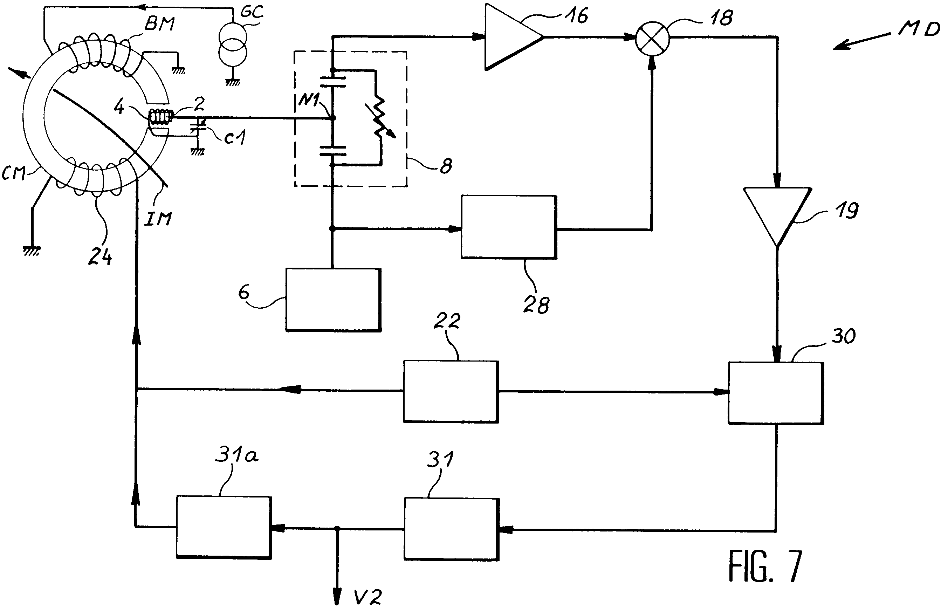

Le capteur conforme à l'invention, qui est schématiquement représenté sur la figure 7, utilise une contre-réaction de champ, ce qui permet d'obtenir un capteur dont la linéarité est meilleure que celle des capteurs des figures 2 et 5.

Le capteur conforme à l'invention, qui est schématiquement représenté sur la figure 7, est en fait un perfectionnement du capteur conforme à l'invention qui a été décrit en faisant référence à la figure 5, en liaison avec la figure 1.

En plus du circuit électronique que l'on voit sur la figure 5, le capteur représenté sur la figure 7 comprend un intégrateur 31 qui intègre la tension Vs fournie par le moyen de détection synchrone 30 et un convertisseur tension-courant 31a qui peut être une simple résistance électrique et qui reçoit en entrée la tension ainsi intégrée pour fournir en sortie un courant qui alimente également la bobine 24.

On voit aussi que le filtre passe-bande 26 de la figure 5 a été remplacé, dans le capteur de la figure 7, par un amplificateur basse fréquence 19 qui amplifie la tension de sortie du mélangeur équilibré 18 et fournit cette tension amplifiée au moyen de détection synchrone 30.

Dans le capteur de la figure 7, le champ supplémentaire résultant du courant à mesurer crée un signal d'erreur qui est superposé à la courbe de résonance et utilisé pour annuler le champ magnétique dû au courant à mesurer, grâce à la boucle de contre-réaction qui comprend l'intégrateur 31, le convertisseur de tension-courant 31a et la bobine 24 qui a donc une fonction supplémentaire dans le capteur de la figure 7, à savoir la production du champ de contre-réaction (qui annule le champ engendré par le courant à mesurer).

Le courant de contre-réaction est une image du courant à mesurer et la tension de sortie V2 de l'intégrateur 31 est proportionnelle à ce courant à mesurer.

En fait, au lieu d'une seule bobine 24, on pourrait utiliser deux bobines, l'une pour la création du champ d'agitation et l'autre pour la création du champ de contre-réaction, ces deux bobines étant bobinées sur le circuit magnétique CM ou placées dans l'entrefer autour de l'échantillon 2 (les axes de ces bobines étant alors parallèles à H1ex).

On pourrait même bobiner l'une de ces deux bobines sur le circuit magnétique et placer l'autre autour de l'échantillon 2.

Dans une variante de réalisation, correspondant au cas où le convertisseur tension-courant 31a est une résistance électrique, la sortie de l'intégrateur 31 est directement reliée à une borne de la bobine de contre-réaction (bobine 24 dans le cas de la figure 7) et cette résistance électrique est montée entre l'autre borne de la bobine de contre-réaction et la masse, ce qui permet de récupérer la tension V2 en cette autre borne de la bobine de contre-réaction.

Par rapport à la réalisation de la figure 7, cette variante (non représentée) présente un avantage : le capteur correspondant permet de mesurer strictement le courant IM alors que, dans le cas de la figure 7, la mesure est perturbée par l'apparition d'un terme réactif- dû à l'inductance de la bobine de contre-réaction- dans le facteur de proportionnalité reliant la tension V2 à l'intensité du courant de contre-réaction.

L'avantage d'un capteur conforme à l'invention et utilisant une contre-réaction, par rapport aux capteurs correspondant aux figures 2 et 5, est qu'il permet de mesurer un courant d'intensité quelconque, avec une grande dynamique et une grande précision.

Le gain de ce capteur ne dépend que du nombre de spires de la bobine de contre-réaction et du gain du convertisseur tension-courant 31a.

Pour l'utilisation d'une contre-réaction dans le domaine de la magnétométrie, on pourra se reporter au document suivant :

(10) demande de brevet français n°8717566 du 16 décembre 1987, J.Crescini et D. Duret - voir aussi US-A-4916393.

Les capteurs conformes à l'invention, qui ont été décrits en faisant référence aux figures 2, 5 et 7, présentent un inconvénient qui est lié à la stabilité du champ de polarisation Hb dont toutes variations sont interprétées comme une variation du champ magnétique engendré par le courant à mesurer.

Ceci pose un problème lors de la mesure d'un courant de très faible intensité, qui nécessite un champ de polarisation Hb de très grande stabilité.

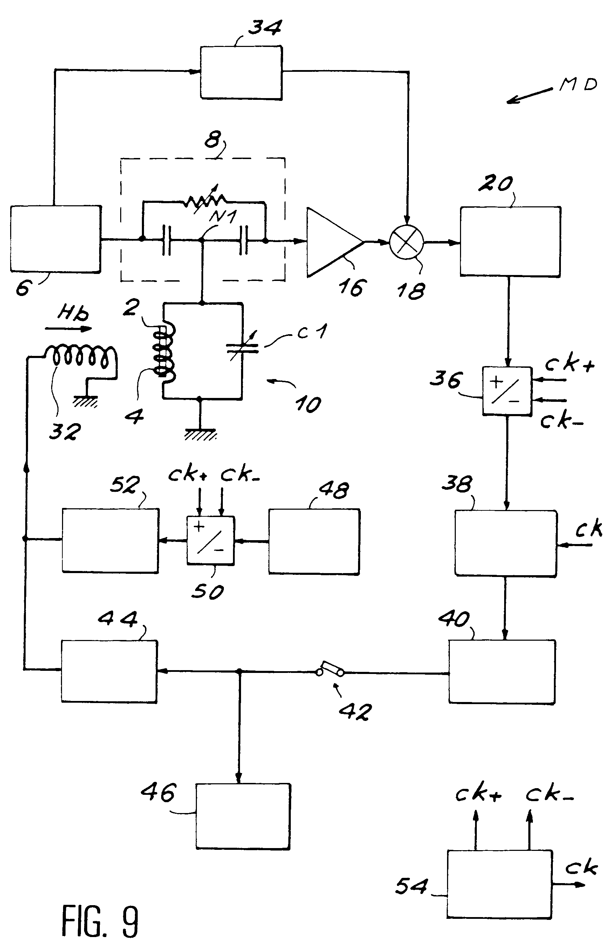

On décrit maintenant un capteur de courant conforme à l'invention qui comporte un circuit magnétique CM, que l'on voit sur la figure 8, ainsi qu'un magnétomètre directionnel à résonance MD que l'on voit sur la figure 9, et qui résout le problème de stabilité mentionné plus haut.

Ce magnétomètre de la figure 9 ne présente pas de dérives liées au temps ou à la température et a une meilleure résolution que les magnétomètres directionnels à résonance des figures 2, 5 et 7.

Pour ce faire, le magnétomètre représenté sur la figure 9 utilise un champ de polarisation Hb pulsé en créneaux.

Le magnétomètre directionnel à résonance MD qui est schématiquement représenté sur la figure 9, comprend l'ensemble des éléments référencés 2, 4, 6, 8, 10, 16, 18 et 20 sur la figure 2 et agencés de la même façon que sur cette figure 2.

L'échantillon utilisable dans la présente invention et en particulier dans les figures annexées, est par exemple l'un de ceux qui sont décrits aux pages 3 et 4 du document suivant :

(11) Demande de brevet français n°8612278 du 1 septembre 1986, M. Dufour et C. Salvi.

Mais, de préférence, on utilise l'un des matériaux qui sont des phtalocyanines de lithium octasubstituées et qui sont décrits dans le document suivant :

(12) Demande de brevet français n°8809831 du 20 juillet 1988 - voir aussi US-A-4 996 331.

On aboutit ainsi à un magnétomètre et donc à un capteur de courant conforme à l'invention qui sont très performants.

On ajoutera que la taille du magnétomètre représenté sur la figure 9 ainsi que d'ailleurs la taille des magnétomètres des figures annexées, peut être réduite à une valeur de l'ordre de quelques millimètres, en utilisant les techniques de la microélectrique pour leur réalisation.

Dans le cas de la figure 9, le champ de polarisation est créé par une bobine qui porte la référence 32 et qui est alimentée d'une manière expliquée par la suite.

Comme on le voit sur la figure 8, cette bobine 32 est bobinée sur le circuit magnétique CM qui, dans l'exemple représenté, épouse sensiblement la forme d'un carré, abstraction faite de son entrefer.

Ainsi, la bobine 32 crée dans l'entrefer ER du circuit CM un champ de polarisation qui est perpendiculaire à l'axe de la bobine 4 qui se trouve dans cet entrefer ER.

Dans une variante de réalisation non représentée, la bobine 32 est placée dans l'entrefer ER, autour de l'échantillon 2 et son axe est parallèle au champ H1ex.

Le magnétomètre de la figure 9 comporte en outre un déphaseur 34 par l'intermédiaire duquel le signal de haute fréquence fo du générateur 6 est fourni au mélangeur équilibré 18 et qui est réglé de façon à déphaser ce signal de telle manière que le filtre passe-bas 20 fournisse en sortie la tension V1 dont les variations en fonction du champ appliqué à l'échantillon 2 sont représentées par la courbe de dispersion de la figure 3.

Le magnétomètre de la figure 9 comprend aussi un dispositif électronique 36, un échantillonneur-bloqueur 38 et un intégrateur 40 qui sont montés à la suite du filtre 20 et dans cet ordre.

La sortie de l'intégrateur 40 est reliée, par l'intermédiaire d'un interrupteur 42 (à deux positions ouvert-fermé), à l'entrée d'un convertisseur tension-courant 44 dont la sortie alimente la bobine 32.

A la sortie de l'interrupteur 42, qui est fermé lors du fonctionnement du magnétomètre de la figure 9, et donc du capteur de courant correspondant, sont montés des moyens d'affichage 46 permettant d'afficher la tension de sortie de l'intégrateur 40.

Le magnétomètre de la figure 9 comprend aussi une source de tension préférentiellement stable et réglable 48 qui permet, par l'intermédiaire d'un dispositif 50, identique au dispositif 36, et d'un convertisseur 52, d'injecter un courant stable dans la bobine 32, cette dernière créant ainsi le champ Hb correspondant approximativement à la fréquence fo.

Chacun des convertisseurs 44 et 52 est par exemple une résistance électrique.

Chacun des dispositifs 36 et 50 est un dispositif électronique commandé par des signaux d'horloge impulsionnels ck+ et ck- et permettant un gain en tension qui vaut +1 lorsque ce dispositif reçoit un signal d'horloge ck+ et -1 lorsqu'il reçoit un signal d'horloge ck-.

L'échantillonneur-bloqueur 38 est par exemple du genre du circuit AD585 de la société Analog Device ; il est commandé par des signaux d'horloge impulsionnels ck pendant lesquels il "suit" le signal qui lui arrive en entrée et entre lesquels il mémorise ce signal.

Les signaux d'horloge ck, ck+ et ck- sont définis par des tensions positives.

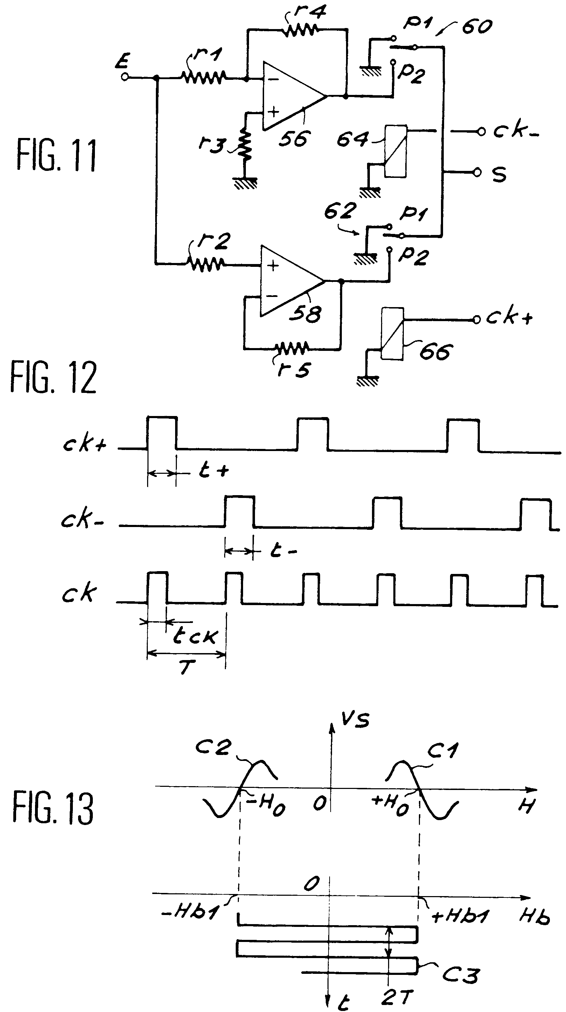

Un générateur de signaux d'horloge 54 permet de commander convenablement les dispositifs 36 et 50 et l'échantillonneur-bloqueur 38 par les signaux ck, ck+ et ck- dont le chronogramme apparaît sur la figure 12.

Ce générateur 54 peut être réalisé au moyen d'un compteur numérique, piloté par une horloge, et de décodeurs d'état, permettant d'obtenir le chronogramme de la figure 12.

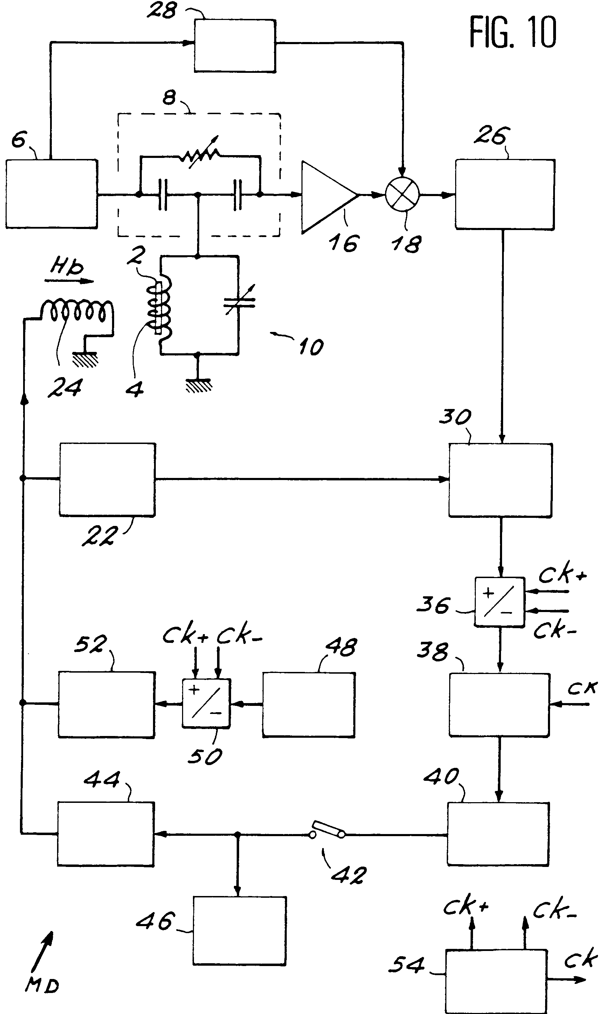

Un autre magnétomètre utilisable dans l'invention est schématiquement représenté sur la figure 10 et utilise une détection synchrone à fréquence audio.

Le magnétomètre MD de la figure 10 comprend l'ensemble des éléments référencés 2, 4, 6, 8, 10, 16, 18, 22, 24, 26, 28 et 30 sur la figure 5 et agencés de la même façon que sur cette figure 5.

Le magnétomètre de la figure 10 comprend aussi les éléments référencés 36, 38, 40, 42, 44, 46, 48, 50, 52 et 54 de la figure 9, agencés comme sur cette figure 9, à ceci près que, dans le cas de la figure 10, la sortie du moyen de détection synchrone 30 est reliée à l'entrée du dispositif 36 et que les convertisseurs 44 et 52 alimentent la bobine 24 (cette dernière étant bobinée sur le circuit magnétique CM ou placée dans l'entrefer ER, autour de l'échantillon 2, et ayant alors son axe parallèle au champ H1ex.

On notera que, dans le cas de la figure 10, la sortie du moyen de détection synchrone 30 fournit la tension Vs dont les variations en fonction du champ appliqué à l'échantillon 2 sont représentées par la courbe de la figure 6.

Un exemple de réalisation connue du dispositif 36 (ou 50) est schématiquement représenté sur la figure 11 et comprend deux amplificateurs différentiels 56 et 58 et deux relais électromagnétiques 60 et 62 à deux positions p1 (repos) et p2 (travail), dont on voit les bobines respectives 64 et 66 sur la figure 11.

L'entrée E du dispositif de cette figure 11 est reliée à l'entrée inverseuse de l'amplificateur 56 par l'intermédiaire d'une résistance r1 et à l'entrée non inverseuse de l'amplificateur 58 par l'intermédiaire d'une résistance r2.

L'entrée non inverseuse de l'amplificateur 56 est mise à la masse par l'intermédiaire d'une résistance r3.

La sortie de cet amplificateur 56 est reliée à son entrée inverseuse par l'intermédiaire d'une résistance r4.

La sortie de l'amplificateur 58 est reliée à son entrée inverseuse par l'intermédiaire d'une résistance r5.

A titre d'exemple, les résistances r1, r2, r4 et r5 valent 100 kiloohms tandis que la résistance r3 vaut 47 kiloohms.

Entre deux impulsions ck-, le relais 60 est en position p1 et, pendant chaque impulsion ck-, en position p2 dans laquelle la sortie S du dispositif de la figure 11 est reliée à la sortie de l'amplificateur 56.

Entre deux impulsions ck+, le relais 62 est en position p1 et, pendant chaque impulsion ck+, en position p2 dans laquelle la sortie S est reliée à la sortie de l'amplificateur 58.

On décrit maintenant le chronogramme de la figure 12.

Les signaux ck sont des impulsions de largeur temporelle tck et de période T.

Les signaux ck+ sont des impulsions de largeur temporelle t+, supérieure à tck, et de période 2T.

Les signaux ck- sont des impulsions de largeur temporelle t-, supérieure à tck, et de période 2T.

Les impulsions ck sont alternativement recouvertes par des impulsions ck+ et par des impulsions ck-.

On explique ci-après le fonctionnement des magnétomètres des figures 9 et 10.

Supposons l'interrupteur 42 ouvert.

La valeur de l'intensité I du courant dans la bobine 24 (ou 32) est réglée de telle façon que le champ H correspondant (champ total auquel est soumis l'échantillon) soit approximativement "au centre" de la résonance (H peu différent de Ho).

La variation de la tension V1 (ou Vs) à la sortie du filtre 20 (ou du moyen de détection synchrone 30), pour une variation de H positive ou négative, est donnée par la double courbe C1-C2 de la figure 13.

Dans ce qui suit, pour faciliter la description, la notation "VS" représentera aussi bien V1 que Vs définis plus haut.

C1 est une courbe du genre de celle de la figure 3 ou de la figure 6 et C2 est symétrique de C1 par rapport à l'axe des ordonnées VS.

Pendant une impulsion ck+ du chronogramme de la figure 12, la tension à la sortie du filtre 20 (ou du moyen de détection synchrone 30) vaut :

$$VS+ = -K.(Hb - Ho + H1ex) + Voff$$

K étant une constante de proportionnalité positive correspondant à la partie approximativement linéaire de la courbe de la figure 13 et Voff une tension de décalage, tension résiduelle prenant en compte les défauts de l'appareillage électronique.

L'expression ci-dessus de VS+ est valable si H1ex est suffisamment petit pour que l'on reste dans la partie linéaire de la courbe de la figure 13.

Pendant une impulsion ck-, la tension à la sortie du filtre 20 (ou du moyen de détection synchrone 30) vaut :

$$VS- = K.(-(Hb - Ho) + H1ex) + Voff$$

puisque, pendant une impulsion ck-, on se situe du côté des valeurs négatives de H et le dispositif 50 transforme la valeur Vo de la tension fournie par la source 48 en la valeur opposée -Vo.

On voit sur la figure 13 que le champ de polarisation Hb varie alors au cours du temps sous la forme d'impulsions en créneaux (courbe C3), entre deux valeurs Hb1 et -Hb1, Hb1 étant proportionnel à Vo.

La valeur-crête (Hb1) de ce balayage correspond au maximum de la pente de la courbe de la figure 3 (ou 6) à la résonance (H=Ho).

Les erreurs du magnétomètre viennent des variations de la tension Vo fournie par la source 48 et de Voff (qui représente les dérives de l'appareillage électronique).

Nous allons montrer que les magnétomètres des figures 9 et 10 compensent ces erreurs.

A la sortie du dispositif 36, la tension VS est inversée pendant l'impulsion ck-.

L'échantillonneur-bloqueur 38 mémorise ses valeurs d'entrée pendant les temps morts et les échantillonne pendant les impulsions ck qui apparaissent "à l'intérieur" des impulsions ck+ et ck-, conformément au chronogramme de la figure 12.

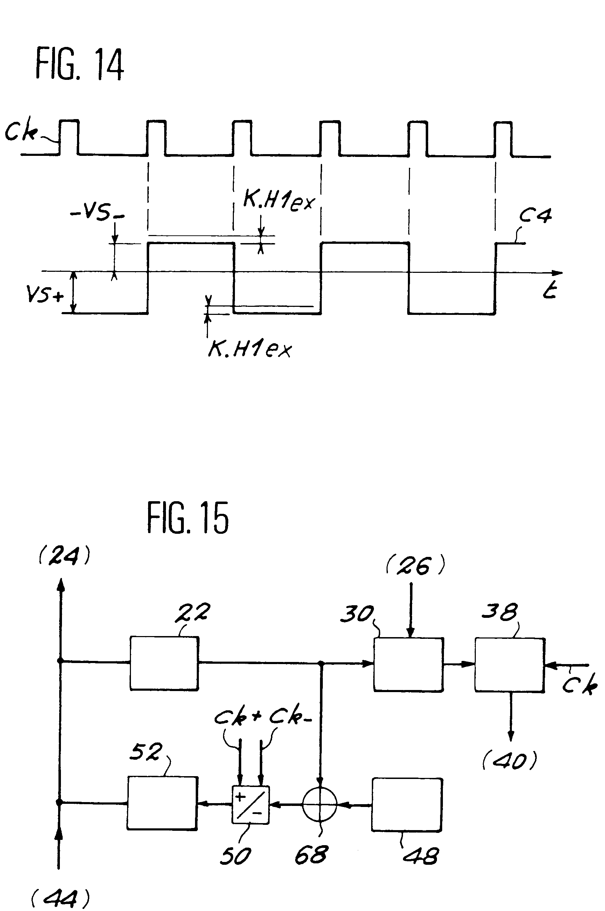

Le signal qui est présent à la sortie de l'échantillonneur-bloqueur 38 est représenté par la courbe C4 de la figure 14.

C'est une succession des valeurs

$$- K(Hb - Ho + H1ex) + Voff \text{ et } - K(-(Hb - Ho) + H1ex) - Voff$$

soit VS+ et -VS-, dont la valeur moyenne est :

$$((VS+) + (-VS-))/2 = -K.H1ex.$$

Si H1ex varie lentement (c'est-à-dire si l'intensité du courant à mesurer varie lentement), il est ainsi possible de suivre ses variations par un simple filtrage passe-bas en sortie de l'échantillonneur-bloqueur 38.

De la sorte, les dérives lentes sont éliminées.

En fait, on est en présence d'un système échantillonné dont la fréquence d'échantillonnage fe est l'inverse du temps T séparant deux impulsions ck.

Conformément à la théorie de tels systèmes, la bande passante maximale du signal d'entrée (H1ex) est égale à fe/2.

Lorsque l'interrupteur 42 est fermé, le signal de sortie de l'échantillonneur-bloqueur 38 intervient en tant que signal d'erreur dans une boucle d'asservissement : sa valeur moyenne est maintenue à zéro par cette boucle et, par l'intermédiaire de l'intégrateur 40 et du convertisseur 44, un courant de contre-réaction est engendré dans la bobine 24 (ou 32) et s'oppose aux variations de H1ex.

Dans ce cas, pourvu que le système ait été "accroché" sur la résonance, le "suivi" peut largement excéder la partie linéaire de la courbe de la figure 13 puisque l'on est toujours centré sur la résonance.

Au premier ordre, la linéarité ne dépend plus que du transfert entre le courant et le champ dans la bobine 24 (ou 32).

A la sortie de l'interrupteur 42 (fermé), on obtient un signal de tension qui constitue une image du champ de contre-réaction et qui est proportionnel à H1ex.

Les moyens d'affichage 46 permettent alors de connaître H1ex et donc l'intensité du courant à mesurer IM.

L'interrupteur 42 peut être supprimé, l'intégrateur 40 étant alors directement relié au convertisseur 44, et dans ce cas les moyens d'affichage 46 sont reliés à la sortie de l'intégrateur 40.

Une variante de réalisation du magnétomètre de la figure 10 est schématiquement et partiellement représentée sur la figure 15.

Dans cette variante, on utilise encore une détection synchrone à la fréquence audio fm mais le dispositif 36 est supprimé.

L'inversion de signe que ce dispositif réalisait est remplacée par une commutation de 180°, à chaque impulsion ck-, de la phase du signal d'excitation de fréquence fm.

Comme on le voit sur la figure 15, on utilise pour ce faire un moyen de sommation 68 qui est monté entre la source de tension 48 et le dispositif 50.

Ce moyen de sommation 68 reçoit en entrée la tension Vo fournie par la source 48 et le signal de fréquence fm issu de l'oscillateur 22 et fournit au dispositif 50 la somme de ces derniers.

Dans les magnétomètres des figures 9 et 11, l'utilisation d'un générateur symétrique de signaux d'horloge 54, tel que t+ et t- soient égaux à T, permet de supprimer l'échantillonneur-bloqueur 38, la sortie du dispositif 36 étant alors directement reliée à l'intégrateur 40.

On notera que les magnétomètres des figures 9, 10 et 15 se distinguent essentiellement des magnétomètres des figures 2, 5 et 7 par l'utilisation d'un champ de polarisation Hb pulsé en créneaux.

L'utilisation d'un champ Hb pulsé permet de supprimer les dérives lentes en temps et température, surtout celles du courant de polarisation I (envoyé dans la bobine 24 ou 32).

L'utilisation d'un champ en créneaux (de période 2T dans le cas de la figure 12) permet de travailler à l'endroit de pente maximale (par réglage de Vo dans le cas des figures 9, 10 et 15) de la courbe de dispersion ou de la dérivée de la courbe d'absorption et donc d'améliorer le rapport signal/bruit.

L'échantillonneur-bloqueur permet d'éviter des oscillations parasites susceptibles de se produire lors de l'alimentation de la bobine 24 ou 32 par un courant en créneaux.

La diminution de t+ et de t- par rapport à T (figure 12) permet de réduire la puissance dissipée dans la bobine 24 ou 32 et donc la consommation du magnétomètre en énergie.

L'utilisation d'un champ Hb en créneaux associé à un échantillonneur-bloqueur permet par ailleurs de réduire la consommation du magnétomètre.

On notera également un autre avantage des magnétomètres des figures 9 et 10, à savoir la compensation des tensions de décalage ("offset") et des dérives, inhérentes à un appareillage électronique.

Le capteur objet de la présente invention n'est pas limité à la résonance paramagnétique électronique.

Il peut utiliser une résonance magnétique nucléaire : l'échantillon utilisé dans l'invention peut contenir des spins nucléaires, par exemple protoniques, au lieu de spins électroniques.

Dans une variante de réalisation du magnétomètre représenté sur la figure 9, la bobine 32 est seulement reliée au convertisseur 52 et permet de créer le champ de polarisation Hb.

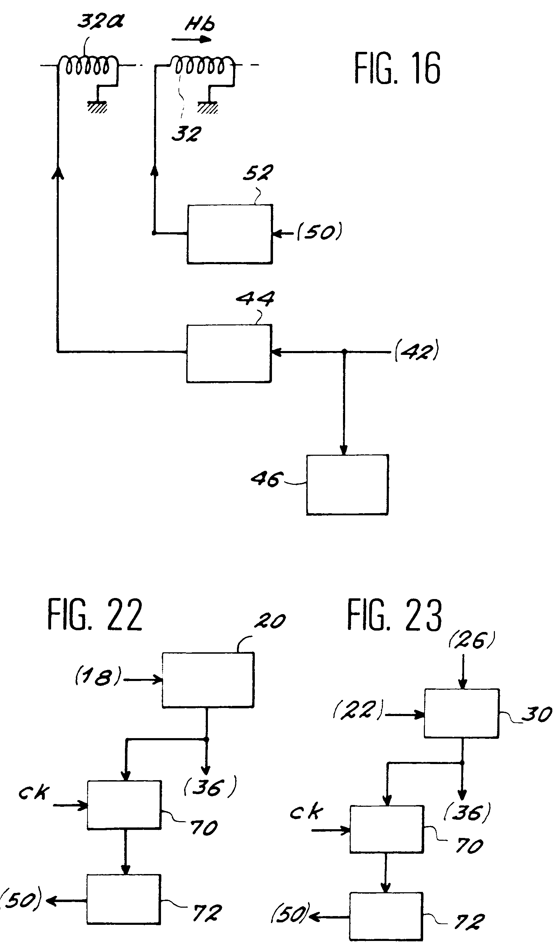

Une autre bobine 32a (figure 16) est reliée, d'un côté, à la masse et, de l'autre, à la sortie du convertisseur 44 et cette bobine 32a est prévue pour compenser le champ H1ex.

Les bobines 32 et 32a peuvent être toutes deux bobinées sur le circuit magnétique CM.

En variante, elles sont placées dans l'entrefer ER, sont bobinées autour de l'échantillon 2 et ont un même axe qui est parallèle au champ magnétique créé dans l'entrefer ER par le courant à mesurer (l'axe de la bobine 4 étant perpendiculaire à ce champ).

Dans une autre variante, l'une des bobines 32 et 32a est bobinée sur le circuit magnétique CM et l'autre bobine est placée dans l'entrefer ER, est bobinée autour de l'échantillon et son axe est parallèle au champ magnétique créé dans l'entrefer par le courant à mesurer.

Dans une variante de réalisation du magnétomètre représenté sur la figure 10, la bobine 24 est seulement reliée à l'oscillateur 22 et permet de créer le champ d'agitation à fréquence audio.

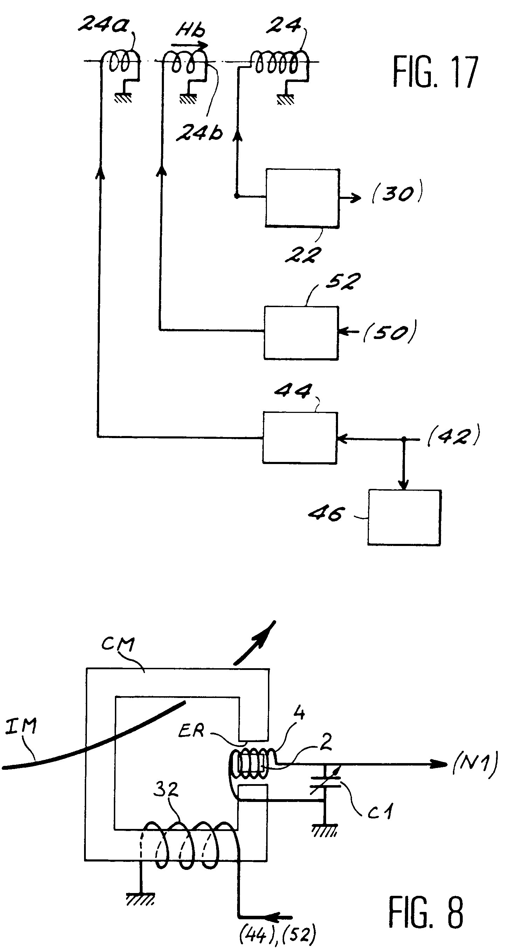

Une autre bobine 24a (figure 17) est reliée, d'un côté, à la masse et, de l'autre, à la sortie du convertisseur 44 et cette bobine 24a est prévue pour compenser le champ H1ex.

Une bobine supplémentaire 24b est reliée, d'un côté, à la masse et, de l'autre, à la sortie du convertisseur 52, et permet de créer le champ de polarisation Hb.

Les bobines 24, 24a et 24b peuvent être toutes trois bobinées sur le circuit magnétique CM.

En variante, elles sont placées dans l'entrefer ER, sont bobinées autour de l'échantillon 2 et ont un même axe qui est parallèle au champ magnétique créé dans l'entrefer ER par le courant à mesurer.

Dans d'autres variantes, une (respectivement deux) de ces trois bobines est bobinée (respectivement sont bobinées) sur le circuit magnétique et les deux autres (respectivement l'autre) sont placées dans l'entrefer, sont bobinées autour de l'échantillon, et ont le même axe qui est parallèle au champ H1ex (respectivement est placée dans l'entrefer, bobinée autour de l'échantillon et son axe est parallèle au champ H1ex.

Dans une variante non représentée du magnétomètre de la figure 10, on utilise deux bobines ; l'une de ces deux bobines est reliée à l'un des trois éléments portant les références 22, 44 et 52 en vue de remplir l'une des trois fonctions suivantes : création de Hb, création du champ d'agitation et compensation de H1ex ; l'autre des deux bobines est reliée aux deux autres des trois éléments en vue de remplir les deux autres fonctions ; par exemple, l'une des deux bobines est reliée à l'oscillateur 22 pour engendrer le champ d'agitation et l'autre bobine est reliée aux convertisseurs 44 et 52 en vue de créer le champ de polarisation Hb et de compenser le champ H1ex.

Le circuit résonant 10 (voir figures 9 et 10), qui est accordé à la fréquence fo, peut se dérégler.

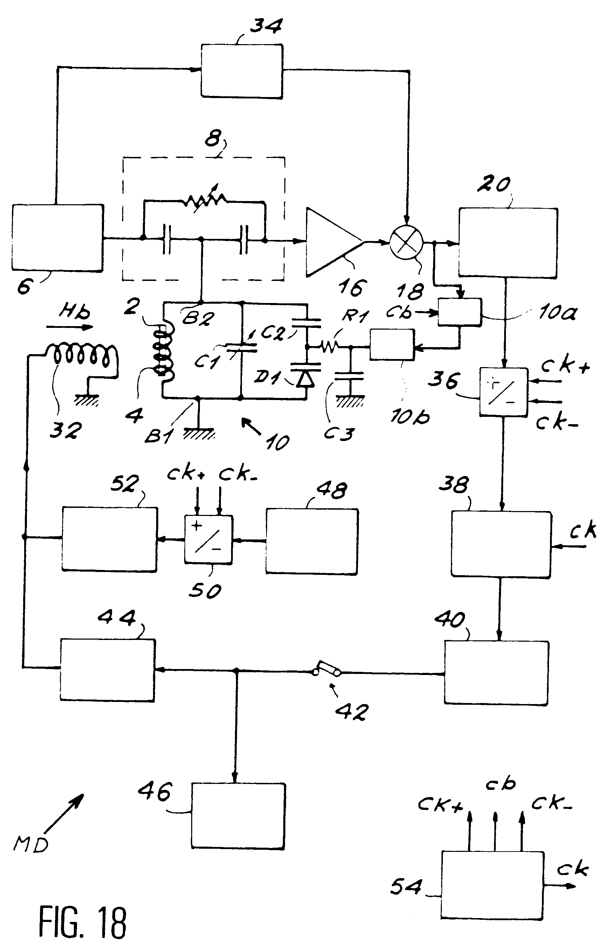

Pour maintenir ce circuit résonant 10 accordé à la fréquence fo, on peut modifier le magnétomètre représenté sur la figure 9 comme on l'explique ci-après en faisant référence à la figure 18.

On ajoute au circuit résonant 10 un condensateur c2, une diode à capacité variable D1, une résistance de polarisation R1 et un condensateur c3.

De plus, on ajoute au magnétomètre de la figure 9 un échantillonneur-bloqueur 10a et un intégrateur 10b.

A titre purement indicatif et nullement limitatif, la diode D1 est du genre de celle qui est commercialisée par RTC sous la référence 0F 643, la résistance R1 vaut 100 kilo-ohms et les condensateurs c2 et c3 ont tous deux une capacité de 10 nF.

La borne B1 du circuit résonant 10, qui est commune à la bobine 4 et au condensateur variable c1 et qui est mise à la masse, est reliée à l'anode de la diode D1.

La cathode de cette diode D1 est reliée à une borne du condensateur c2 (qui a pour fonction d'éviter la mise en court-circuit de la diode D1 par la bobine 4) et à une borne de la résistance R1.

L'autre borne du condensateur c2 est reliée à l'autre borne B2 du condensateur variable c1.

L'échantillonneur-bloqueur 10a est commandé par des signaux d'horloge impulsionnels cb et son entrée est reliée à la sortie du mélangeur équilibré 18 tandis que sa sortie est reliée à l'entrée de l'intégrateur 10b.

La sortie de ce dernier est reliée à l'autre borne de la résistance R1 ainsi qu'à une borne du condensateur c3 dont l'autre borne est mise à la masse et qui a pour fonction d'éviter des fuites de signaux de haute fréquence vers l'intégrateur 10b, ces signaux provenant du générateur 6.

Les signaux cb, qui servent à commander l'échantillonneur-bloqueur 10a, sont définis par des tensions positives.

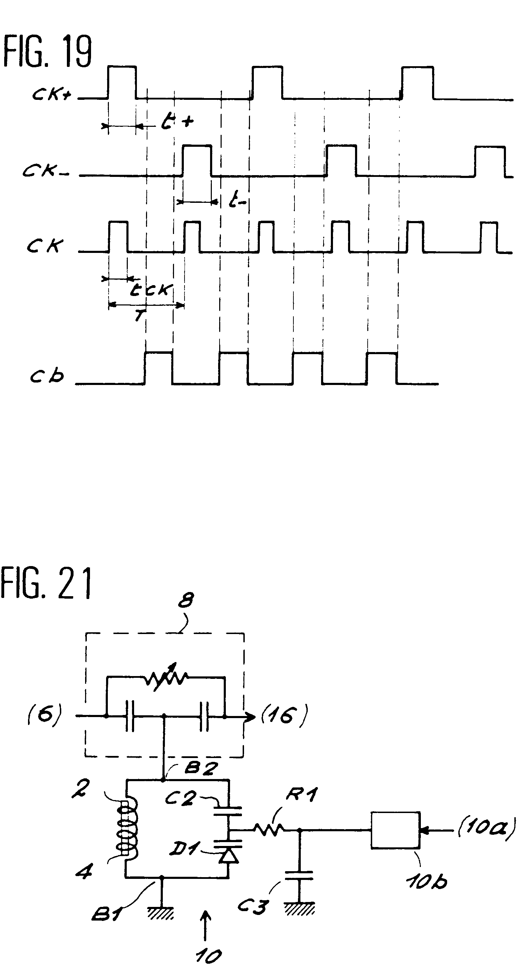

Ces signaux cb, dont le chronogramme apparaît sur la figure 19, sont des signaux logiques en créneaux dont les impulsions non nulles apparaissent en dehors de celles des signaux ck+ et ck-.

Comme ces derniers, les signaux cb sont fournis par le générateur 54 qui est convenablement modifié de façon à obtenir le chronogramme de la figure 19.

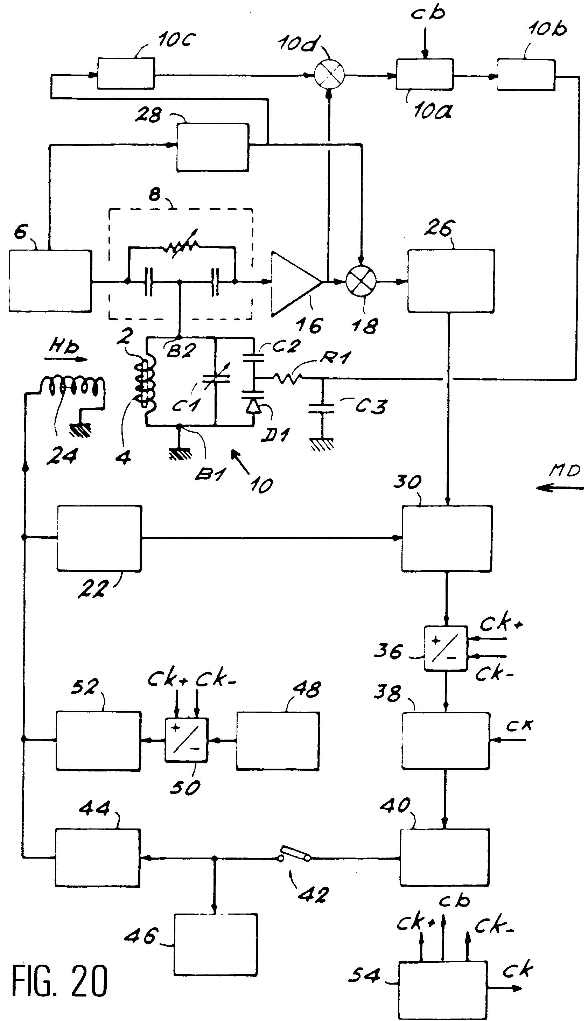

Le magnétomètre MD de la figure 10 peut être modifié comme on l'explique ci-après, en faisant référence à la figure 20 pour maintenir son circuit résonant 10 accordé à la fréquence fo.

On ajoute au magnétomètre de la figure 10 les éléments qui portent les références c2, c3, D1, R1, 10a et 10b agencés de la même façon que dans la figure 18 excepté que l'entrée de l'échantillonneur-bloqueur 10a n'est pas, dans le cas de la figure 20, relié à la sortie du mélangeur 18 : pour obtenir le magnétomètre de la figure 20, on ajoute en outre au magnétomètre de la figure 10 un déphaseur 10c et un autre mélangeur équilibré 10d (du même type que le mélangeur 18) ; le déphaseur 10c reçoit le signal de haute fréquence issu du déphaseur 28 et fournit au mélangeur 10d un signal de référence qui est déphasé de +90° ou de -90° par rapport au signal de référence du mélangeur 18, le signe de ce déphasage étant choisi tel que l'asservissement de l'accord du circuit résonant soit stable ; le signal de sortie de l'amplificateur 16 est aussi envoyé à l'entrée du mélangeur 10d dont la sortie est reliée à l'entrée de l'échantillonneur-bloqueur 10a.

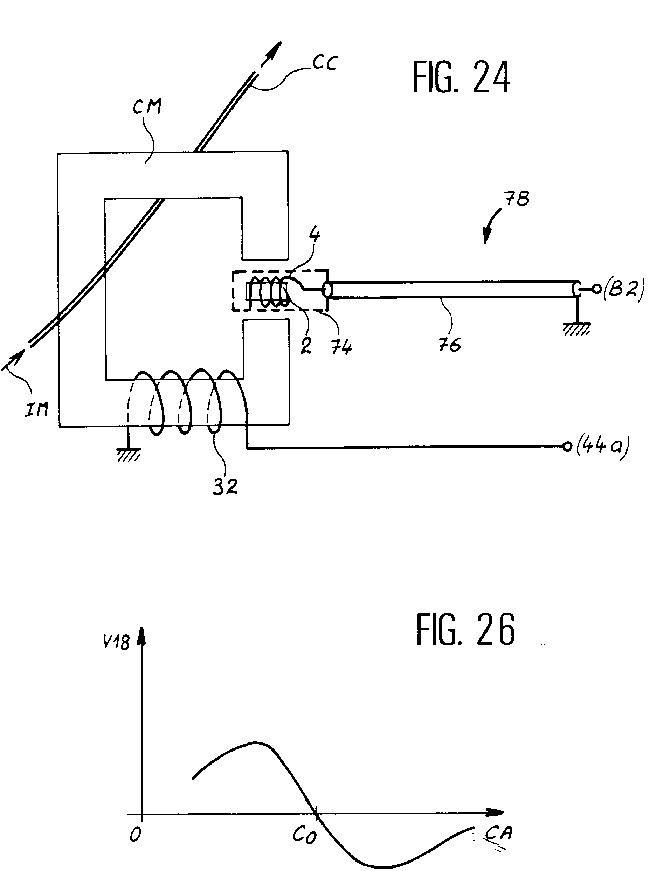

Dans une variante de réalisation, le condensateur variable c1 des figures 18 et 20 est supprimé comme on le voit sur la figure 21 : alors l'ensemble D1-c2 est simplement monté entre les bornes B1 et B2.

Les magnétomètres MD représentés sur les figures 9, 10, 18 et 20 peuvent être avantageusement munis de moyens aptes à maintenir automatiquement la polarisation de l'échantillon 2 à une valeur Hb1 égale à Ho (ou plus exactement à maintenir respectivement égales à Ho et à -Ho les valeurs maximale Hb1 et minimale -Hb1 de Hb et ce, de manière automatique), en asservissant la source de tension 48 à un signal d'erreur Veps obtenu en faisant l'opération :

$$Veps = (VS+) + (VS-) = -2K.(Hb - Ho) + 2Voff.$$

Si l'on sait faire en sorte que Voff soit petit, ou, plus exactement, soit négligeable devant K.(Hb-Ho), ce qui est possible en utilisant des circuits électroniques à faible dérive, le terme Veps permet d'asservir la tension Vo de telle façon que Hb1 soit strictement égale à Ho.

En l'absence d'un tel asservissement, une légère variation de Hb1 autour de Ho n'introduit pas de dérive des magnétomètres mais conduit à une dégradation du rapport signal sur bruit dès que l'on sort te la zone de pente maximale de la courbe de la figure 3 ou de la courbe de la figure 6 (voir aussi le document (9)).

De plus, le réglage de la source 48 à la valeur Vo peut être délicat si la raie de résonance est fine, c'est-à-dire si DH1 et DH2 sont faibles devant Ho.

Le maintien automatique de la polarisation de l'échantillon à la valeur Ho est donc avantageux en ce qu'il permet d'exploiter ces magnétomètres avec un rapport signal sur bruit optimal et d'éviter le réglage de la source de tension 48.

Ce maintien automatique est obtenu (voir figures 22 et 23) en remplaçant la source 48 par l'association d'un échantillonneur-bloqueur 70 identique à celui qui porte la référence 38 et d'un intégrateur 72 identique à celui qui porte la référence 40.

Plus précisément, pour un magnétomètre du genre de celui de la figure 9, le signal de sortie du filtre 20 (figure 22) est envoyé non seulement au dispositif 36 mais aussi à l'entrée de l'échantillonneur-bloqueur 70 qui est commandé par les signaux ck et dont la sortie est reliée à l'entrée de l'intégrateur 72.

La sortie de ce dernier est reliée à l'entrée du dispositif 50.

Pour un magnétomètre du genre de celui de la figure 10, c'est le signal de sortie des moyens de détection synchrone 30 (figure 23) qui est envoyé non seulement au dispositif 36 mais aussi à l'entrée de l'échantillonneur-bloqueur 70.

Ce dernier est encore relié à l'intégrateur 72 lui-même relié au dispositif 50 comme on l'a vu précédemment à propos de la figure 22.

A la sortie de l'intégrateur 72, on a donc une tension Vo proportionnelle à Ho (valeur du champ magnétique reliée à la fréquence fo de résonance des spins par la relation de Larmor).

Dans les capteurs conformes à l'invention qui ont été décrits, la bobine 4 (bobinage radio-fréquence) forme une antenne qui est susceptible de capter des signaux parasites.

Pour remédier à cet inconvénient, on ajoute à un capteur conforme à l'invention un blindage radiofréquence qui est imperméable aux champs radiofréquences dont les fréquences sont voisines de la fréquence de résonance fo du capteur, et qui est perméable au champ magnétique engendré par le courant à mesurer, au champ magnétique de polarisation lorsque ce dernier est engendré par une bobine formée sur le circuit magnétique (cas de la figure 1 par exemple) et, d'une manière générale, aux champs magnétiques de basse fréquence (éventuellement nulle) qui sont susceptibles d'être engendrés par une ou des bobines formées sur ce circuit magnétique.

Ceci est illustré par la figure 24 où la bobine 32, qui sert à engendrer le champ de polarisation pulsé en créneaux et le champ de contreréaction, est formée sur le circuit magnétique CM qui est traversé par le courant à mesurer IM, ce courant étant par exemple transporté grâce à un conducteur électrique CC (qui traverse le circuit magnétique CM).

Sur cette figure 24, on voit le blindage radio-fréquence qui est constitué par une enveloppe 74, par exemple en cuivre, située dans l'entrefer du circuit magnétique CM et renfermant l'échantillon 2 ainsi que la bobine 4.

Une borne de la bobine 4 est électriquement reliée à la paroi interne de l'enveloppe 74 et cette enveloppe 74 est électriquement reliée à la tresse 76 d'un câble coaxial 78, cette tresse 76 étant mise à la masse.

L'autre borne de la bobine 4 est électriquement reliée à une extrémité de l'âme de ce câble coaxial 78 dont l'autre extrémité est le point B2 que l'on voit sur la figure 18.

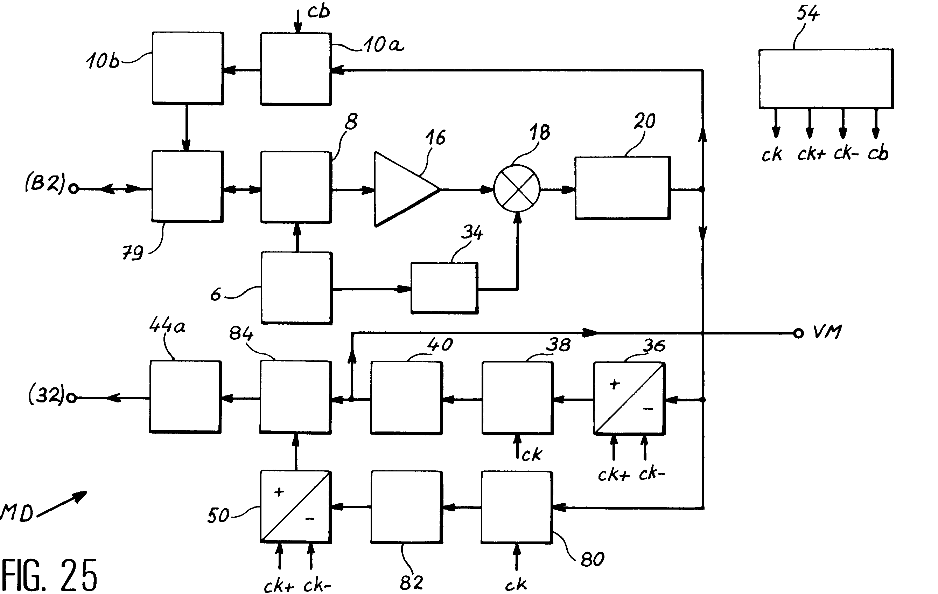

Sur la figure 25, on a représenté schématiquement le circuit électronique MD d'un capteur de courant conforme à l'invention.

Ce circuit électronique est par exemple associé au circuit magnétique CM, à l'échantillon 2 et à la bobine 4, raccordée au câble coaxial 78, que l'on voit sur la figure 24.

Le circuit électronique représenté sur la figure 25 correspond à une variante de réalisation du circuit électronique de la figure 18 ou du circuit électronique qui est partiellement représenté sur la figure 21.

Le circuit électronique de la figure 25 comprend le générateur d'horloge 54 qui fournit les signaux ck, ck+, ck-, cb.

On reconnaît sur la figure 25 le générateur 6 de haute fréquence (oscillateur radio-fréquence) qui excite la résonance par l'intermédiaire du pont de mesure 8 et de la bobine 4.

Sur la figure 25, la boîte qui porte la référence 79 symbolise le circuit d'accord (comprenant, sur la figure 18, les condensateurs c1, c2 et c3, la résistance R1 et la diode D1, et, sur la figure 21, les condensateurs c2 et c3, la résistance R1 et la diode D1).

Le générateur 6 commande également le mélangeur 18 par l'intermédiaire du déphaseur 34, la sortie du pont de mesure 8 arrive à ce mélangeur 18 à travers l'amplificateur 16 et le filtre passe-bas 20 reçoit les signaux issus du mélangeur 18, comme dans le magnétomètre de la figure 18.

A la différence de la figure 18, c'est le signal de sortie du filtre passe-bas 20, et non pas le signal de sortie du mélangeur 18, qui est successivement traité par l'échantillonneur-bloqueur 10a (commandé par les signaux cb) et par l'intégrateur 10b (relié au circuit d'accord).

Dans le circuit de la figure 25, on trouve encore le dispositif 36 qui reçoit le signal de sortie du filtre passe-bas 20 et qui est suivi par l'échantillonneur-bloqueur 38 lui-même suivi par l'intégrateur 40.

On trouve également un échantillonneur-bloqueur 80 qui reçoit en entrée le signal de sortie du filtre passe-bas, qui est commandé par les signaux ck et dont la sortie est reliée à l'entrée d'un intégrateur 82.

Le circuit de la figure 25 comprend en outre le dispositif 50 de la figure 18 dont l'entrée est reliée à la sortie de l'intégrateur 82.

Le circuit de la figure 25 comprend enfin un additionneur 84 dont les deux entrées sont respectivement reliées aux sorties de l'intégrateur 40 et du dispositif 50 et qui alimente la bobine 32 (figure 24) par l'intermédiaire d'un convertisseur de tension-courant 44a (par exemple une résistance électrique).

Le chronogramme des signaux ck, ck+, ck- et cb utilisés dans le circuit de la figure 25 est celui de la figure 19, ce dernier permettant de comprendre le fonctionnement du circuit de la figure 25.

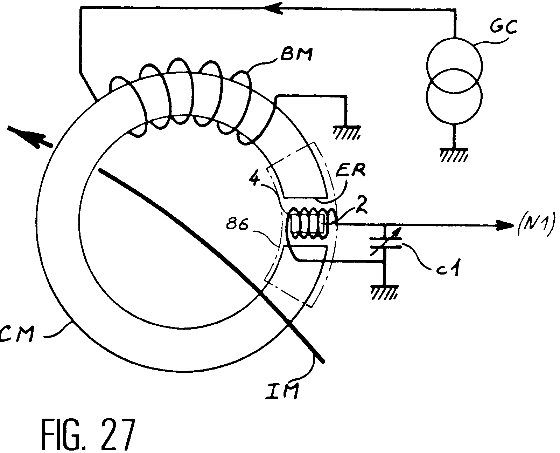

A la sortie du mélangeur équilibré 18, l'effet d'une variation de la capacité d'accord CA autour de la valeur Co correspondant à la résonance est représenté sur la figure 26.

La courbe de cette figure 26 (où V18 désigne la tension de sortie du mélangeur 18) n'est valable que si elle n'est pas perturbée par le phénomène de la résonance des spins du matériau de l'échantillon 2.

Pour s'assurer de ce fait, la mesure n'est effectuée que hors résonance, pendant l'impulsion cb (quand le champ de polarisation est nul) et mémorisée pendant les autres moments.

Cette mesure échantillonnée donne accès au spectre des varations de CA autour de Co à toutes fréquences inférieures à la moitié de la fréquence d'échantillonnage.

De ce fait, ce signal est utilisé pour asservir la capacité à la valeur de résonance Co par la diode à capacité variable D1, ce qui permet à la fois un accord automatique et une compensation des dérives notamment thermiques.

Cette boucle d'accord du circuit résonant est représentée sur la figure 25 par l'échantillonneur-bloqueur 10a, qui est commandé par cb, et par l'intégrateur 10b.

Dans le circuit de la figure 25, la polarisation de l'échantillon 2 est asservie par la boucle qui comprend l'échantillonneur-bloqueur 80, commandé par les signaux ck, l'intégrateur 82, le dispositif 50 (commutation de gain +1/-1) commandé par les signaux ck+ et ck-, l'additionneur 84 et le convertisseur tension-courant 44a qui est relié à la bobine 32 (bobine de champ).

Avec le circuit de la figure 25 la mesure du courant IM est réalisée en prenant la valeur de la tension de sortie VM de l'intégrateur 40.

C'est cette tension VM qui commande l'additionneur 84 et le convertisseur tension-courant 44a dans la chaîne de contre-réaction qui maintient le champ magnétique, au niveau de l'échantillon 2, opposé au champ créé par le courant à mesurer IM, cette chaîne de contre-réaction comprenant le dispositif 36 (commande de gain +1/-1) qui est commandé par les signaux ck et ck-, l'échantillonneur-bloqueur 38 et l'intégrateur 40.

Le circuit de la figure 25 comprend en fait trois boucles de contre-réaction indépendantes :

- une boucle relative à la commande automatique de l'accord du circuit résonant à la fréquence de l'oscillateur radio-fréquence 6, ce qui présente l'avantage d'éliminer les dérives gênantes du circuit, amenant un décalage ("offset") de tension à la sortie de la détection et d'éliminer aussi un réglage de capacité,

- une boucle relative à la polarisation de l'échantillon 2 par un champ Ho (satisfaisant à la relation de Larmor donnée plus haut), ce qui présente l'avantage d'éliminer le réglage de ladite polarisation et les problèmes de dérive liés à une polarisation fixe, et

- une boucle relative au courant à mesurer, ce qui présente l'avantage lié à ce type de contreréaction, c'est-à-dire une amélioration de la linéarité et de la gamme dynamique.

Le circuit magnétique d'un capteur conforme à l'invention joue le rôle d'un écran vis-à-vis du champ magnétique terrestre.

Cependant, pour réduire encore plus l'influence de ce champ et augmenter la précision des mesures, on peut ajouter au circuit magnétique d'un capteur conforme à l'invention un écran en forme de tube, par exemple en Mumétal, comme on le voit sur la figure 27 : cet écran 86 entoure une partie du circuit magnétique CM où est formé l'entrefer de ce circuit.

Pour mesurer l'intensité d'un courant transporté par un conducteur, avec un capteur conforme à l'invention, on peut couper le conducteur, mettre en place le circuit magnétique du capteur, de façon qu'il entoure le conducteur, puis reformer le conducteur.

De façon plus pratique, on peut utiliser une pince du genre pince ampèremètrique, adaptée à l'invention (remplacement de la cellule de Hall d'une telle pince ampèremétrique par un capteur de champ (échantillon 2 et bobine 4) miniaturisé.

Les moyens aptes à créer le champ d'agitation audio, le champ de polarisation et le champ de contreréaction peuvent être constitués par une même bobine, ou deux bobines, ou trois bobines, placées dans l'entrefer ou bobinées autour du circuit magnétique.

## Revendications

1. Capteur de courant comprenant :
   - un circuit magnétique (CM) qui comporte un entrefer (ER), et
   - un dispositif de mesure, apte à fournir une tension électrique représentative d'un champ magnétique H1ex qui est engendré dans l'entrefer par un courant électrique (IM), lorsque ce courant électrique traverse le circuit magnétique, et dont la valeur est une fonction de l'intensité de ce courant électrique, ce capteur étant caractérisé en ce que le dispositif de mesure est un magnétomètre directionnel à résonance (MD) comprenant :
      - un échantillon (2) qui est placé dans l'entrefer, qui est fait d'un matériau comportant des spins résonants et qui est soumis à un champ magnétique de polarisation parallèle au champ magnétique qui est engendré dans l'entrefer (ER) ou confondu avec ce champ engendré dans l'entrefer, et

- des moyens de mesure prévus pour exciter la résonance et détecter la résonance excitée, par l'intermédiaire de premiers moyens magnétiques (4) placés au voisinage de l'échantillon (2), et pour fournir ladite tension électrique représentative.

2. Capteur selon la revendication 1, caractérisé en ce que les moyens de mesure comprennent des moyens de polarisation (BM, GC) prévus pour engendrer le champ magnétique de polarisation Hb, celui-ci étant voisin de Ho où Ho est la valeur du champ magnétique appliqué à l'échantillon à la résonance.

3. Capteur selon la revendication 2, caractérisé en ce que les moyens de polarisation comprennent :
   - une source de courant continu (GC) et
   - une bobine magnétique (BM) qui est alimentée par cette source de courant continu et qui est prévue pour engendrer le champ magnétique de polarisation Hb.

4. Capteur selon l'une quelconque des revendications 1 à 3, caractérisé en ce que les moyens de mesure comprennent en outre des moyens d'asservissement prévus pour engendrer, dans l'échantillon (2), par l'intermédiaire de deuxièmes moyens magnétiques (24, 32, 24a, 32a), un champ magnétique de compensation qui compense le champ magnétique H1ex engendré dans l'entrefer, et pour fournir ladite tension électrique représentative.

5. Capteur selon la revendication 4, caractérisé en ce que les moyens de mesure comprennent en outre des moyens de traitement prévus pour engendrer un courant en créneaux créant, dans l'entrefer, un champ magnétique qui est pulsé entre deux valeurs

   Ho - Hb + H1ex et Hb - Ho + H1ex

   où Ho est la valeur du champ magnétique appliqué à l'échantillon (2) à la résonance et Hb est le champ magnétique de polarisation, celui-ci étant voisin de Ho, et en ce que les deuxièmes moyens magnétiques (24, 32) reçoivent ce courant en créneaux qui est pulsé.

6. Capteur selon la revendication 5, caractérisé en ce que les moyens d'asservissement comprennent un intégrateur (40), qui est commandé par les moyens de traitement, et un convertisseur tension-courant (44) dont l'entrée est reliée à la sortie de l'intégrateur et dont la sortie alimente les deuxièmes moyens magnétiques (24, 32).

7. Capteur selon l'une quelconque des revendications 5 et 6, caractérisé en ce que les moyens de traitement comprennent :
   - des moyens électroniques (6, 8, 16, 18, 20) prévus pour alimenter les premiers moyens magnétiques (4) par un courant à la fréquence de Larmor correspondant à Ho et pour fournir en sortie un signal de tension dont les variations en fonction du champ magnétique appliqué à l'échantillon (2) correspondent à la courbe de dispersion de cet échantillon,
   - un premier dispositif électronique (36) relié à la sortie des moyens électroniques et permettant un gain en tension valant alternativement +1 et -1,
   - un échantillonneur-bloqueur (38) dont l'entrée est reliée à la sortie du premier dispositif électronique (36) et dont la sortie commande les moyens d'asservissement (40, 44),
   - une source de tension électrique (48, 70, 72),
   - un deuxième dispositif électronique (50) alimenté par cette source (48, 70, 72) et permettant un gain en tension valant alternativement +1 et -1, et
   - un autre convertisseur tension-courant (52) dont l'entrée est reliée à la sortie du deuxième dispositif électronique (50) et qui alimente les deuxièmes moyens magnétiques (24, 32, 32a, 24a, 24b).

8. Capteur selon l'une quelconque des revendications 5 et 6, caractérisé en ce que les moyens de traitement comprennent :
   - des moyens électroniques (6, 8, 16, 18, 22, 26, 28, 30) prévus pour alimenter les premiers moyens magnétiques (4) par un courant à la fréquence de Larmor correspondant à Ho et pour fournir en sortie, grâce à une détection synchrone commandée par un signal de tension à une fréquence audio, un signal de tension dont les variations en fonction du champ magnétique appliqué à l'échantillon (2) correspondent à la dérivée de la courbe d'absorption de cet échantillon,
   - un premier dispositif électronique (36) relié à la sortie des moyens électroniques et permettant un gain en tension valant alternativement +1 et -1,
   - un échantillonneur-bloqueur (38) dont l'entrée est reliée à la sortie du premier dispositif électronique (36) et dont la sortie commande les moyens d'asservissement (40, 44),
   - une source de tension électrique (48, 70, 72),

- un deuxième dispositif électronique (50) alimenté par cette source (48, 70, 72) et permettant un gain en tension valant alternativement +1 et -1, et

- un autre convertisseur tension-courant (52) dont l'entrée est reliée à la sortie du deuxième dispositif électronique (50) et qui alimente les deuxièmes moyens magnétiques (24, 32, 32a, 24a, 24b).

9. Capteur selon l'une quelconque des revendications 5 et 6, caractérisé en ce que les moyens de traitement comprennent :

- des moyens électroniques (6, 8, 16, 18, 22, 26, 28, 30) prévus pour alimenter les premiers moyens magnétiques (4) par un courant à la fréquence de Larmor correspondant à Ho et pour fournir en sortie, grâce à une détection synchrone commandée par un signal de tension à une fréquence audio, un signal de tension dont les variations en fonction du champ magnétique appliqué à l'échantillon (2) correspondent à la dérivée de la courbe d'absorption de cet échantillon,

- un échantillonneur-bloqueur (38) dont l'entrée est reliée à la sortie des moyens électroniques et dont la sortie commande les moyens d'asservissement (40, 44),

- une source de tension électrique (48, 70, 72),

- un moyen de sommation (68) prévu pour fournir en sortie un signal de tension égal à la somme de cette tension et d'un signal issu de la détection synchrone à fréquence audio,

- un dispositif électronique (50) relié à la sortie du moyen de sommation (68) et permettant un gain en tension valant alternativement +1 et -1, et

- un autre convertisseur tension-courant (52) dont l'entrée est reliée à la sortie du dispositif électronique (50) et qui alimente les deuxièmes moyens magnétiques (24, 32, 32a, 24a, 24b).

10. Capteur selon l'une quelconque des revendications 5 à 9, caractérisé en ce qu'il comprend en outre des moyens (70, 72) aptes à maintenir respectivement égales à Ho et à -Ho les valeurs maximale et minimale du champ de polarisation.

11. Capteur selon l'une quelconque des revendications 4 à 10, caractérisé en ce que les deuxièmes moyens magnétiques comprennent au moins une bobine magnétique (24, 32) qui est bobinée autour du circuit magnétique (CM).

12. Capteur selon l'une quelconque des revendications 4 à 10, caractérisé en ce que les deuxièmes moyens magnétiques comprennent au moins une bobine magnétique qui est placée dans l'entrefer (ER) et bobinée autour de l'échantillon (2) et dont l'axe est parallèle au champ magnétique engendré dans l'entrefer par le courant à mesurer (IM).

13. Capteur selon l'une quelconque des revendications 1 à 12, caractérisé en ce que les moyens de mesure comprennent un circuit résonant (10), qui incorpore les premiers moyens magnétiques (4) et qui est accordé à la fréquence fo de la résonance, ainsi que des moyens (c2, c3, D1, R1, 10a, 10b; c2, c3, D1, R1, 10a, 10b, 10c, 10d) aptes à maintenir le circuit résonant (10) accordé à la fréquence fo.

14. Capteur selon l'une quelconque des revendications 1 à 13, caractérisé en ce qu'il comprend en outre, autour des premiers moyens magnétiques (4) et de l'échantillon (2), un moyen de protection (86) vis-à-vis du champ magnétique terrestre.

15. Capteur selon l'une quelconque des revendications 1 à 14, caractérisé en ce qu'il comprend en outre, autour des premiers moyens magnétiques (4) et de l'échantillon (2), un moyen de protection (74) vis-à-vis des champs électromagnétiques radio-fréquence.

FIG. 1

FIG. 4

FIG. 2

FIG. 3

FIG. 5

FIG. 6

FIG. 7

FIG. 9

EP 0 519 804 A1

FIG. 10

21

FIG. 11

FIG. 12

FIG. 13

22

# FIG. 14

$Ck$

$-VS_-$

$K.H1ex$

$C4$

$VS+$

$t$

$K.H1ex$

# FIG. 15

(24)

22

(26)

30

38

Ck

(40)

$Ck+$ $Ck-$

52

50 68 48

(44)

FIG. 16

FIG. 22

FIG. 23

FIG. 17

FIG. 8

FIG. 18

FIG. 19

FIG. 21

FIG. 20

EP 0 519 804 A1

28

FIG. 24

FIG. 26

FIG. 25

EP 0 519 804 A1

FIG. 27

EP 0 519 804 A1

Office européen
des brevets

**RAPPORT DE RECHERCHE EUROPEENNE**

Numero de la demande

EP    92 40 1670
Page 1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| Y | SOVIET JOURNAL OF INSTRUMENTATION AND CONTROL. no. 12, Décembre 1968, OXFORD GB pages 3 - 5 L.K. DONDOSHANSKII ET AL. 'D.C.-TO-FREQUENCY CONVERTER BASED ON NUCLEAR MAGNETIC RESONANCE' * le document en entier * | 1 | G01R19/00 G01R33/24 G01R15/02 |
| A | | 14 | |
| D,Y | EP-A-0 359 598 (COMMISSARIAT A L'ENERGIE ATOMIQUE) * colonne 4, ligne 5 - ligne 51 * * colonne 5, ligne 18 - colonne 6, ligne 47 * * colonne 9, ligne 40 - ligne 51; figures 1-3 * | 1 | |
| A | | 2,6-9 | |
| P,Y | EP-A-0 463 919 (COMMISSARIAT A L'ENERGIE ATOMIQUE) * le document en entier * | 1-13 | |
| Y | US-A-3 573 616 (KAHEN) * abrégé; figure 1 * | 1-13 | G01R |
| A | US-A-4 114 087 (FRY) * colonne 4, ligne 65 - colonne 5, ligne 25 * * colonne 6, ligne 40 - ligne 56; figures 1-4,7,11 * | 1 | |
| A | US-A-3 128 425 (CODRINGTON) * colonne 3, ligne 38 - colonne 4, ligne 59; figures 1-3 * | 5,10 | |

DOMAINES TECHNIQUES RECHERCHES (Int. Cl.5 )

-/--

Le présent rapport a été établi pour toutes les revendications

| Lieu de la recherche | Date d'achèvement de la recherche | Examinateur |
|---|---|---|
| LA HAYE | 24 SEPTEMBRE 1992 | SINAPIUS G.H. |

EP 0 519 804 A1

**Office européen des brevets**

**RAPPORT DE RECHERCHE EUROPEENNE**

Numero de la demande

EP 92 40 1670
Page 2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | VDI ZEITSCHRIFT.<br>vol. 115, no. 13, Septembre 1973,<br>DUSSELDORF DE<br>pages 1038 - 1039<br>NT25954 'HOCHGENAUES MESSEN DER<br>MAGNETISCHEN FELDSTÄRKE'<br>* page 1038, colonne de gauche, dernier alinéa - colonne de droite, alinéa 1 *<br>* page 1039, colonne du milieu, alinéa 2 - colonne de droite, alinéa 1; figures 1,2 *<br><br>----- | 1,3,6,<br>11,13 | |
| | | | **DOMAINES TECHNIQUES RECHERCHES (Int. Cl.5)** |

Le présent rapport a été établi pour toutes les revendications

| Lieu de la recherche | Date d'achèvement de la recherche | Examinateur |
|---|---|---|
| LA HAYE | 24 SEPTEMBRE 1992 | SINAPIUS G.H. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)

33